# EUROPÄISCHE PATENTSCHRIFT

(11) **EP 4 314 780 B1**
(45) Veröffentlichungstag und Bekanntmachung des Hinweises auf die Patenterteilung: **27.11.2024**
(21) Anmeldenummer: 22716931.5
(22) Anmeldetag: 21.03.2022
(51) Int. Cl.: G01N 21/67, G01L 21/32, G01L 21/34, H01J 37/32, H05H 1/24, H01J 41/02

(54) **VAKUUMDURCHFÜHRUNG, ELEKTRODENANORDNUNG UND VORRICHTUNG ZUR ERZEUGUNG EINER STILLEN PLASMAENTLADUNG**
VACUUM FEEDTHROUGH, ELECTRODE ASSEMBLY, AND DEVICE FOR GENERATING A SILENT PLASMA DISCHARGE
TROU D'INTERCONNEXION SOUS VIDE, ENSEMBLE ÉLECTRODE ET DISPOSITIF POUR GÉNÉRER UNE DÉCHARGE DE PLASMA SILENCIEUSE

(30) Priorität: 31.03.2021 CH 3412021
(43) Veröffentlichungstag der Anmeldung: 07.02.2024
(73) Patentinhaber: Inficon AG, 9496 Balzers (LI)
(72) Erfinder: ANDREAUS, Bernhard, 8640 Rapperswil (CH); WALDNER, Astrid, 7310 Bad Ragaz (CH)
(74) Vertreter: Troesch Scheidegger Werner AG
(86) Internationale Anmeldenummer: PCT/EP2022/057385
(87) Internationale Veröffentlichungsnummer: WO 2022/207397

(56) Entgegenhaltungen:
- EP-A1- 3 410 462
- WO-A1-2021/052600
- US-A1- 2018 313 763

## Beschreibung

Die vorliegende Erfindung betrifft eine Vakuumdurchführung, eine Elektrodenanordnung und eine Vorrichtung zur Erzeugung einer stillen Plasmaentladung. Weiter betrifft die Erfindung ein Messgerät zur Charakterisierung einer Druck- und/oder Gaszusammensetzung und ein Verfahren zum Betrieb des Messgeräts.

Die vorliegende Erfindung gehört zum technischen Gebiet der Plasmaerzeugung, dem Ionisieren und Anregen von Molekülen und Ionen, um Plasmalicht zu erzeugen, und weiter, der Messung und Auswertung von Informationen über die Gaszusammensetzung des erzeugten Plasmas. Eine mögliche Art der Plasmaentladung ist die sogenannte DBD-Plasmaentladung. Eine DBD-Plasmaentladung (auch stille elektrische Entladung oder auch dielektrische Barriereentladung genannt, englisch "dielectric barrier discharge", abgekürzt DBD) ist eine Wechselspannungs-Gasentladung, bei der mindestens eine der Elektroden vom Gasraum durch galvanische Trennung mittels eines Dielektrikums elektrisch isoliert ist. Man spricht auch von dielektrisch behinderter Entladung, da durch die Isolierung das Entstehen einer Bogenentladung verhindert wird.

Die Messung und Auswertung des in einem DBD-Plasma erzeugten Lichts ist mit vielerlei Schwierigkeiten verbunden. Lebensdauer und gegebenenfalls Vakuumtauglichkeit von Elementen, Grösse und Komplexität von Aufbauten sowie die erreichbare Empfindlichkeit sind stellen grosse Herausforderungen dar.

Die in WO 2021/052600 A1 beschriebene vakuumdichte elektrische Durchführung umfasst ein elektrisch isolierendes Isolator-Element mit einer Durchgangsöffnung, mit einer an die Durchgangsöffnung angrenzenden ersten Begrenzungsfläche und mit einer ebenfalls an die Durchgangsöffnung angrenzenden, der ersten Begrenzungsfläche gegenüberliegenden zweiten Begrenzungsfläche. Die vakuumdichte elektrische Durchführung umfasst weiter ein elektrisch leitendes Leiter-Element, welches sich durch die Durchgangsöffnung hindurch erstreckt und welches entlang einer Umfangslinie des Leiter-Elements vakuumdicht mit dem Isolator-Element verbunden ist. Das Isolator-Element ist für elektromagnetische Strahlung in einem optischen Wellenlängenbereich durchlässig. Die erste und/oder die zweite Begrenzungsfläche ist als gekrümmte Fläche ausgebildet. Die gekrümmte Fläche kann insbesondere als konvexe oder konkave Fläche ausgebildet sein.

Die Aufgabe der vorliegenden Erfindung bestand darin, zumindest eines der Probleme des Stands der Technik zu vermindern. Namentlich ist ein Ziel der Erfindung, einen kompakten Sensor für Druck und/oder Gaszusammensetzung basierend auf einer DBD-Plasmaentladung zu ermöglichen und dazu geeignete Komponenten zur Verfügung zu stellen. Diese Aufgabe wird erfindungsgemäss durch eine Vakuumdurchführung nach Anspruch 1 gelöst. Ausführungsformen ergeben sich aus den Merkmalen der abhängigen Ansprüche 2 bis 4.

Die Vakuumdurchführung umfasst die Elemente
- Linsenelement,
- erster Ring aus Glas,
- erster Hohlzylinder aus einem ersten dielektrischen Material,
- erste elektrisch leitende Schicht,
- zweiter Hohlzylinder aus Glas,
- dritter Hohlzylinder aus Keramik,
- zweiter Ring aus Glas,
- Rahmen aus Metall,
in der genannten Abfolge radial von innen nach aussen.

Der Rahmen kann insbesondere ringförmig sein. Der Rahmen kann insbesondere aus Edelstahl sein.

Es existiert zumindest ein durchgehender Strahlungspfad für eine Strahlung aus einem optischen Wellenlängenbereich ausgehend von einem ersten Punkt auf einer ersten Seite, durch das Linsenelement hindurch zu einem zweiten Punkt auf einer zweiten Seite der Vakuumdurchführung.

Das Linsenelement ist transparent für mindestens einen Wellenlängenbereich im optischen Wellenlängenbereich und stellt damit den optischen Teil der Vakuumdurchführung dar. Soweit die Elemente der Vakuumdurchführung nicht transparent sind im besagten Wellenlängenbereich lassen sie den Durchgang entlang dem mindestens einen durchgehenden Strahlungspfad unversperrt. Der optische Wellenlängenbereich umfasst elektromagnetische Strahlung mit Wellenlängen von 100 nm bis 1 mm, also insbesondere die Bereiche des sichtbaren Lichts, der UV-Strahlung und der Infrarot-Strahlung. Das Linsenelement kann beispielsweise die Form einer plan-konvexen Linse haben, wobei die konvexe Seite in Richtung der ersten Seite der Dichteben gerichtet ist. Das Linsenelement kann beispielsweise eine Pilzkopfartige Durchmesservergrösserung auf der ersten Seite aufweisen, sodass ein radialer Überlapp mit dem ersten Ring entsteht. Auf diese Weise kann von der ersten Seite her eintreffende Strahlung gebündelt werden. Beispielsweise kann das Linsenelement durch die Kombination von Linsenradien und Brechungsindex dazu ausgelegt sein, von der ersten Seite her eintreffende parallele Strahlungspfade auf der zweiten Seite in einem Brennpunkt, oder zumindest in einem Brennvolumen, zu konzentrieren.

Die erste Seite kann insbesondere als Vakuumseite und die zweite Seite kann insbesondere als Atmosphärenseite vorgesehen sein. Der Begriff Vakuumdurchführung soll im Zusammenhang mit vorliegender Erfindung so verstanden werden, dass die Durchführung dafür geeignet ist, in einer Situation mit einer erheblichen Druckdifferenz zwischen der ersten und der zweiten Seite eingesetzt zu werden, ohne dass ein Gas durch die Dichtfläche hindurch auf die andere Seite gelangt. Diese Anforderung ist typisch für die Verwendung einer Durchführung in der Vakuumtechnik, kann aber auch in anderen Anwendungen von Nutzen sein, in denen auf keiner Seite ein Druck im Vakuumbereich herrscht.

Die erfindungsgemässe Vakuumdurchführung ist also eine elektrisch-optische Vakuumdurchführung. Die erste elektrisch leitende Schicht bildet isoliert vom Rahmen die elektrische Durchführung. Das Linsenelement bildet die optische Durchführung.

Optional kann auf einer zentralen Achse des Linsenelements zusätzlich eine Stab- oder Drahtförmige Elektrode durch das Linsenelement hindurchgeführt werden, wobei diese weitere Elektrode mittels eines weiteren Rings aus Glas eingeglast sein kann. Eine solche weitere Elektrode kann im Fall, dass eine Spannungsversorgung weiterer Elemente erforderlich ist, den gesamten Aufbau kompakt halten.

In einer Ausführungsform der erfindungsgemässen Vakuumdurchführung sind die aneinandergrenzenden Elemente (Elemente sind das Linsenelement und die weiteren Elemente aus der obigen Liste) vakuumdicht miteinander verbunden zur Ausbildung einer Dichtfläche, welche eine erste Seite, insbesondere eine Vakuumseite, und eine zweite Seite, insbesondere eine Atmosphärenseite, der Vakuumdurchführung voneinander trennt.

Auf der Aussenfläche des ersten Hohlzylinders ist die erste elektrisch leitende Schicht aufgebracht. Diese elektrisch leitende Schicht kann aus einem Metall, insbesondere aus Platin sein.

Der erste Hohlzylinder und die erste elektrisch leitende Schicht ragen auf der Atmosphärenseite über den zweiten Hohlzylinder hinausragen zur Ausbildung einer elektrischen leitenden Kontaktfläche. An der Kontaktfläche kann die erste Elektrode z.B. mit einer Hochspannungsquelle verbunden werden, sodass die erste elektrisch leitende Schicht als eine Elektrode für die DBD-Plasmaentladung dienen kann. Die erste elektrisch leitende Schicht kann die Form eines Hohlzylinders haben. Die erste elektrisch leitende Schicht kann segmentiert sein, d.h. beispielsweise im Bereich, in dem Sie als Elektrode für die DBD-Entladung dient und/oder im Bereich der Durchführung unter dem Glasring als nebeneinander liegende Längsstreifen ausgebildet sein.

Der erste, der zweite und der dritte Hohlzylinder, sowie die erste elektrisch leitende Schicht ragen auf der ersten Seite über das Linsenelement hinaus.

Die Elemente bilden jeweils eine im Wesentlichen ringförmige Zone der Dichtfläche aus. Der erste Ring aus Glas grenzt radial ausserhalb an das Linsenelement an und ist mit dem Linsenelement vakuumdicht verbunden. Der erste Hohlzylinder grenzt radial ausserhalb an den ersten Ring an und ist mit diesem vakuumdicht verbunden, usw. In dieser Anordnung hat jede Schicht zumindest eine benachbarte Schicht aus Glas. Der erste und der zweite Ring aus Glas, sowie der zweite Hohlzylinder, können insbesondere aus Schmelzglas bestehen. Das Schmelzglas kann insbesondere ein sogenanntes Lotglas sein, welches sich besonders gut zur Herstellung einer vakuumdichten Verbindung zu einem Metall oder einer Keramik eignet. Der metallische Rahmen kann in Form eines Rings ausgebildet sein. Der metallische Rahmen kann beispielsweise einen Flansch aufweisen, welcher so ausgestaltet ist, dass er ein Verschweissen des Rahmens mit weiteren Elementen erleichtert. Der metallische Rahmen kann beispielsweise aus einem nichtrostenden austenitischen Stahl bestehen, beispielsweise aus Stahl 1.4435 oder aus Stahl 1.4404, welcher sich durch eine hohe Korrosionsbeständigkeit auszeichnet.

Die Elemente können je einzeln die Form eines Rotationskörpers mit einer Rotationsachse haben. Die Elemente können bezüglich ihrer Rotationsachsen koaxial zueinander angeordnet sein.

Auf der ersten Seite, d.h. beispielsweise vakuumseitig, kann die elektrisch leitende Schicht komplett zwischen dem ersten und zweiten Hohlzylinder eingeschlossen sein. In diesem Fall ist vakuumseitig nur eine kapazitive Ankopplung an die Elektrode möglich. Ein komplettes Einschliessen der elektrisch leitenden Schicht in isolierendes Material hat den Vorteil, dass das Entstehen einer Bogenentladung verhindert werden kann.

Der dritte Hohlzylinder aus Keramik hat die Wirkung, einen elektrischen Durchschlag durch den zweiten Hohlzylinder aus Glas zu unterdrücken, für den Fall, dass das Glas nicht ausreichend durchschlagsresistent ist. Beispielsweise wird eine Entladung zwischen einem Metallgehäuse-Rohr eines im Folgenden noch zu besprechenden Messgeräts durch den dritten Hohlzylinder aus Keramik erfolgreich verhindert. Der dritte Hohlzylinder kann insbesondere aus einer Al₂O₃-Keramik bestehen.

In einer Ausführungsform der Vakuumdurchführung besteht das Linsenelement aus Saphir.

Saphir hat einen hohen Transmissionsgrad im Wellenlängenbereich 200 nm bis 5000 nm und damit besonders geeignet, um elektromagnetische Strahlung aus dem optischen Bereich mit geringem Verlust aus einem Vakuumbereich hinauszuführen. Insbesondere ist die Transmission im Ultraviolett-Bereich oberhalb von 200 nm hoch. Ausserdem ist Saphir mechanisch sehr robust.

In einer Ausführungsform der Vakuumdurchführung besteht der erste Hohlzylinder aus Saphir.

Weiter ist die Erfindung auf eine Elektrodenanordnung nach Anspruch 5 gerichtet. Eine Ausführungsform der Elektrodenanordnung ergibt sich aus den Merkmalen des Anspruchs 6.

Die erfindungsgemässe Elektrodenanordnung ist eine Elektrodenanordnung zur Erzeugung einer DBD-Plasmaentladung. Die Elektrodenanordnung umfasst die oben besprochene erfindungsgemässe Vakuumdurchführung. Sie umfasst weiter einen vierten Hohlzylinder aus Keramik, welcher auf seiner Aussenfläche eine zweite, elektrisch leitende Schicht trägt. Die zweite elektrisch leitende Schicht kann insbesondere aus Molybdän sein.

Der vierte Hohlzylinder ist auf der ersten Seite (der Vakuumseite) der Vakuumdurchführung koaxial zum ersten Hohlzylinder angeordnet. Er liegt zumindest teilweise innerhalb des ersten Hohlzylinders. Die erste und die zweite elektrisch leitende Schicht überlappen in axialer Richtung teilweise.

Zwischen der zweiten elektrisch leitenden Schicht und der Innenfläche des ersten Hohlzylinders bleibt ein Spalt mit einer radialen Ausdehnung offen.

Die erste und die zweite elektrisch leitende Schicht bilden die beiden Elektroden der Elektrodenanordnung. Im Betrieb bildet sich im besagten Spalt eine Plasmaentladungszone aus, und zwar in axialer Richtung in dem Bereich, in dem die beiden Elektroden überlappen.

Der vierte Hohlzylinder hat den Effekt eines Sputterschutzes. Er erhöht die Lebensdauer der Elektrodenanordnung. Der vierte Hohlzylinder kann beispielsweise aus einer Al₂O₃-Keramik bestehen. Eine weitere Massnahme, welche einen Sputterschutz bewirkt, ist die Dimensionswahl der Durchführung. Ein grosser Abstand zwischen Linsenelement zur Region der Plasmaentladung reduziert den Sputtereffekt auf das Linsenelement.

Insbesondere ein grosser Abstand in Relation zum Durchmesser des Linsenelements ist hierzu wirksam.

In einer Ausführungsform der Elektrodenanordnung beträgt die radiale Ausdehnung des Spalts weniger als 1 mm. Die radiale Ausdehnung des Spalts kann insbesondere zwischen 0.05 mm und 0.5 mm betragen. Die Erfinder haben erkannt, dass sich mit dieser Ausdehnung des Spalts die DBD-Plasmaentladung mit einer hochfrequenten Spannung im Kilovolt-Bereich (1 - 10 kV, 1 - 10 kHz) über einen grossen Druckbereich zünden lässt. Der Betrieb in einem Druckbereich von ca. 0.047 - 199.98 kPa (0.35 - 1500 Torr) ist möglich.

Ausserdem betrifft die Erfindung eine Vorrichtung nach Anspruch 7.

Die erfindungsgemässe Vorrichtung ist eine Vorrichtung zur Erzeugung einer DBD-Plasmaentladung. Die Vorrichtung umfasst die oben besprochene, erfindungsgemässe Elektrodenanordnung. Der Spalt zwischen der zweiten elektrisch leitenden Schicht und der Innenfläche des ersten Hohlzylinders steht in fluiddynamischer Verbindung mit dem Innern der Vakuumkammer.

Die erste elektrisch leitende Schicht ist an der elektrischen leitenden Kontaktfläche mit einer Wechselspannungs-Hochspannungsquelle elektrisch leitend verbunden ist und die zweite elektrisch leitende Schicht ist elektrisch leitend mit Masse verbunden.

Die Elektrodenanordnung kann beispielsweise in eine metallische Wandung einer Vakuumkammer eingebaut sein, wobei der Rahmen an seinem Umfang mit der Wandung der Vakuumkammer vakuumdicht verschweisst ist. Durch den grossen Druckbereich in welchem mit der erfindungsgemässen Vorrichtung eine DBD-Entladung möglich ist, kann ein Betrieb der Vorrichtung beispielsweise auch in Umgebungsdruck, d.h. ohne eine Kammer, welche die erste von der zweiten Seite fluiddynamisch trennt, stattfinden.

Noch weiter ist die Erfindung auf ein Messgerät nach Anspruch 8 gerichtet.

Das erfindungsgemässe Messgerät ist ein Messgerät zur Charakterisierung eines Drucks und/oder einer Gaszusammensetzung. Das Messgerät umfasst die oben besprochene erfindungsgemässe Vorrichtung zur Erzeugung einer DBD-Plasmaentladung. Zusätzlich ist auf der Atmosphärenseite des Linsenelements ein optischer Sensor angeordnet.

Der optische Sensor ist in dem Wellenlängenbereich empfindlich, welche durch das Linsenelement transmittiert werden kann. Der optische Sensor kann ein einfacher Strahlungssensor, z.B. ein Lichtsensor sein, es kann sich aber auch um einen komplexeren optischen Sensor handeln, z.B. ein Spektrometer. Eine Photodiode mit einem wellenlängenselektiven Filter kann beispielsweise als optischer Sensor dienen.

Das erfindungsgemässe Messgerät eignet sich beispielsweise zur Charakterisierung einer Druck- und/oder Gaszusammensetzung innerhalb einer Vakuumkammer. Die optimale Verwendung der Erfindung liegt im Druckbereich von 0.35-1500 Torr (-2000 mbar), also auch im Druckbereich bei und über Atmosphärendruck und ist daher breit einsetzbar. Die spezifische Wahl der verwendeten Materialien kann gemäss den oben erwähnten Ausführungsformen spezifisch auf Vakuumanforderungen angepasst werden. Namentlich die Verwendung von Saphir als Dielektrikum, von Platin und Molybdän als Elektrodenmaterial und von Edelstahl für den Rahmen tragen zur Vakuumtauglichkeit des Messgeräts bei. Weiter sind die genannten Materialien mit den typischen Anforderungen einer Vakuum-Prozess-Anlage der HalbleiterIndustrie verträglich.

Weiter ist die Erfindung auf ein Verfahren nach Anspruch 9 gerichtet. Es handelt sich dabei um ein Verfahren zum Betrieb eines erfindungsgemässen Messgeräts. Im erfindungsgemässen Verfahren wird zwischen der ersten elektrisch leitenden Schicht und der zweiten elektrisch leitenden Schicht eine Wechselspannung mit einer Spannungsamplitude von 1 bis 10 Kilovolt und einer Frequenz im Bereich 1 bis 10 Kilohertz angelegt. Beispielsweise kann der Spannungsverlauf über eine Periode der Wechselspannung von -5 kV zu +5kV und wieder zurück wechseln, d.h. eine Spannung von 10 kVpp angelegt werden. Der Spannungsverlauf kann beispielsweise einem Sinus-Verlauf entsprechen. Eine Rechteck-Spannung ist ebenfalls möglich. Vorteilhaft ist es, die Spannung von positiv zu negativ gegenüber Massepotential zu variieren. Auf diese Weise erhält man ein deutlich stabileres Plasma als beispielsweise durch eine Variation zwischen 0 und positiver Spannung oder zwischen 0 und negativer Spannung.

Durch das Anlegen der Spannung wird im Spalt zwischen zweiter elektrisch leitender Schicht und dem Dielektrikum im Bereich des axialen Überlappungsbereich der beiden elektrisch leitenden Schichten ein Plasma gezündet, welches aufgrund der Ladungsansammlung auf dem Dielektrikum nur eine kurze Lebensdauer hat. Durch den Wechsel des Vorzeichens der angelegten Wechselspannung werden die angesammelten Ladungsträger wieder vom Dielektrikum wegbewegt, sodass ein kontinuierlich scheinendes Plasma aufrechterhalten werden kann. Die vom Plasma emittierte Strahlung wird im optischen Sensor detektiert.

Ausführungsbeispiele der vorliegenden Erfindung werden nachstehend anhand von Figuren noch näher erläutert. Es zeigen
Fig. 1 schematisch und teilweise als Querschnitt eine erfindungsgemässe Vakuumdurchführung im Zusammenhang mit einer Ausführungsform der Elektrodenanordnung, einer Ausführungsform der Vorrichtung und einer Ausführungsform des Messgeräts;
Fig. 2 einen Querschnitt durch die erfindungsgemässe Vakuumdurchführung entlang der Dichtfläche;
Fig. 3 einen Querschnitt durch eine Ausführungsform der Vakuumdurchführung entlang der Dichtfläche;
Fig. 4 einen Querschnitt durch eine weitere Ausführungsform der Vakuumdurchführung entlang der Dichtfläche.

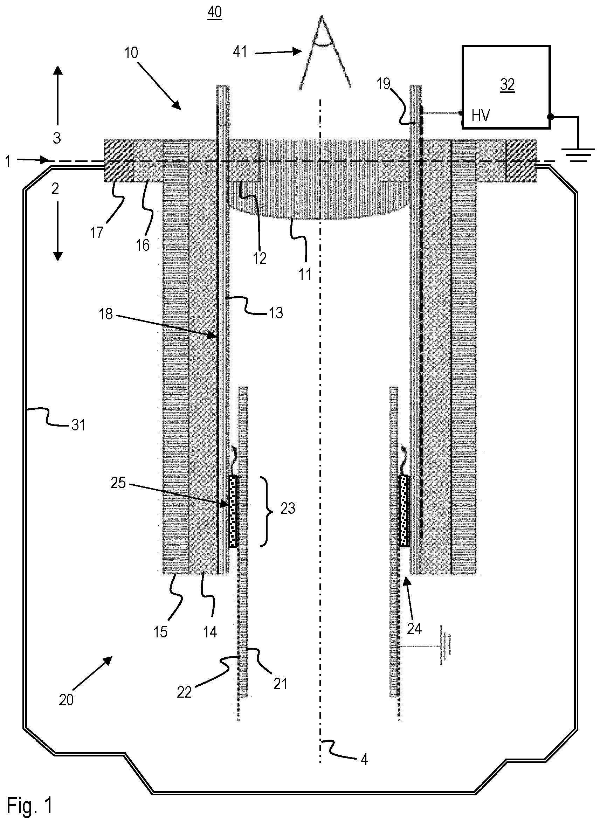

In Figur 1 ist in einem Längsschnitt das zentrale Element der Erfindung, nämlich die Vakuumdurchführung, gezeigt. Die in radialen Lagen aufgebaute elektro-optische Vakuumdurchführung 10 umfasst ein zentral angeordnetes Linsenelement 11 und um das Linsenelement herum angeordnet folgende weitere Elemente, in radialer Richtung von innen nach aussen aufgezählt:
- ein erster Ring 12 aus Glas,
- ein erster Hohlzylinder 13 aus einem ersten dielektrischen Material,
- ein zweiter Hohlzylinder 14 aus Glas,
- ein dritter Hohlzylinder 15 aus Keramik,
- ein zweiter Ring 16 aus Glas,
- ein Rahmen 17 aus Metall.

Weiter ist auf der Aussenfläche des ersten Hohlzylinders eine erste elektrisch leitende Schicht 18 aufgebracht, welche insbesondere aus Platin sein kann.

Eine Dichtfläche 1 trennt eine erste Seite 2, in diesem Fall die Vakuumseite, welche ins Innere der Vakuumkammer 31 zu liegen kommt, von einer zweiten Seite 3, welche in diesem Fall die Atmosphärenseite ist. Im gezeigten Längsschnitt ist die Dichtfläche 1 entlang einer Linie geschnitten, welche als gestrichelte Linie dargestellt ist. Auf der Atmosphärenseite einer Vakuumkammer 31 sind ein optischer Sensor 41 und eine Hochspannungsquelle 32 untergebracht. Ein vierter Hohlzylinder 21 und die auf dessen Aussenfläche angebrachte zweite elektrisch leitende Schicht 22 ergänzen die Vakuumdurchführung zu einer Elektrodenanordnung 20. In der gezeigten Ausführungsform haben die Elemente der Elektrodenanordnung alle die Form von Rotationskörpern mit der gemeinsamen Rotationsachse 4 (strichpunktierte Linie).

Eine erste elektrisch leitende Schicht 18 ist an einer Kontaktfläche 19 an die Hochspannungsquelle 32 angeschlossen. Die zweite elektrisch leitende Schicht ist mit Masse verbunden, sodass erste und zweite elektrisch leitende Schicht die beiden Elektroden der Elektrodenanordnung bilden. Die beiden Elektroden überlappen in einem axialen Überlappungsbereich 23. In diesem Überlappungsbereich und radial zwischen der zweiten elektrisch leitenden Schicht 22 und dem Hohlzylinder 13, welcher insbesondere aus Saphir sein kann, bildet sich im Betrieb ein Entladungsbereich 25 aus (gepunktet dargestellt). Aus diesem Entladungsbereich heraus wird elektromagnetische Strahlung, z.B. aus dem sichtbaren Bereich, dem UV-Bereich oder dem IR-Bereich, emittiert. Diese Strahlung kann insbesondere in Richtung auf das Linsenelement in abgestrahlt werden (durch wellenförmige Pfeile dargestellt). Es ist diese Strahlung, welche durch das Linsenelement 11 hindurch zum optischen Sensor 41 gelangt, wo sie detektiert wird.

Die erste 18 und zweite 22 elektrisch leitende Schicht können in axialer Richtung beispielsweise 2-3 mm überlappen. Der vierte Hohlzylinder 21 kann beispielsweise ca. 5 mm über die zweite elektrisch leitende Schicht 22 hinaus vorstehen in Richtung auf das Linsenelement zu. Der kürzeste Abstand von der zweiten elektrischen Schicht 22 zum Linsenelement 11 kann beispielsweise ca. 10 mm betragen. Diese Dimensionen passen zu einem Entladungsbereich mit einer radialen Ausdehnung von 0.05 bis 0.5 mm, gemäss einer oben beschriebenen Ausführungsform. Mit den genannten Abstandsverhältnissen entsteht die schon oben erwähnte Sputterschutz-Wirkung. Durch die Entladung aus dem Elektrodenmaterial herausgeschlagene Teilchen werden in dieser Anordnung mit einer hohen Wahrscheinlichkeit an der vorstehenden Keramikfläche des vierten Hohlzylinders hängen bleiben und damit nicht das Linsenelement verschmutzen. Strahlung aus dem Entladungsbereich 25 kann in etwa parallel zur Achsenrichtung zum Linsenelement gelangen, auch wenn der vierte Hohlzylinder selbst nicht transparent ist für die Strahlung oder bereits durch Elektrodenmaterial verschmutzt ist.

Gezeigt ist eine Ausführungsform Messgerät resp. Vorrichtung, bei welcher die Elektrodenanordnung in eine metallische Wandung einer Vakuumkammer 31 eingebaut ist, wobei der Rahmen an seinem Umfang mit der Wandung der Vakuumkammer vakuumdicht verschweisst ist.

Insbesondere die Vakuumkammer 31 und der Wandung, sowie Hochspannungsquelle 32 und optischer Sensor 41 sind sehr schematisch dargestellt und bezüglich Dimensionen nicht an die Dimensionen der Elektrodenanordnung angepasst. Insbesondere die Vakuumkammer kann in Relation zur Vakuumdurchführung um ein Vielfaches grösser sein als dargestellt. Ebenfalls schematisch und unvollständig dargestellt ist das vom Linsenelement weiter entfernte Ende des vierten Hohlzylinders und der zweiten elektrisch leitenden Schicht. Die axialen Enden dieser beiden Elemente sind zueinander versetzt dargestellt, sodass die beiden Lagen deutlich erkennbar sind. Die beiden Elemente können sich in axialer Richtung aber weiter erstrecken als gezeigt und die zweite elektrische leitende Schicht kann insbesondere über ihre ganze Länge auf dem vierten Hohlzylinder aufliegen. Eine nicht gezeigte mechanische Befestigungsvorrichtung hält den vierten Hohlzylinder in seiner Position.

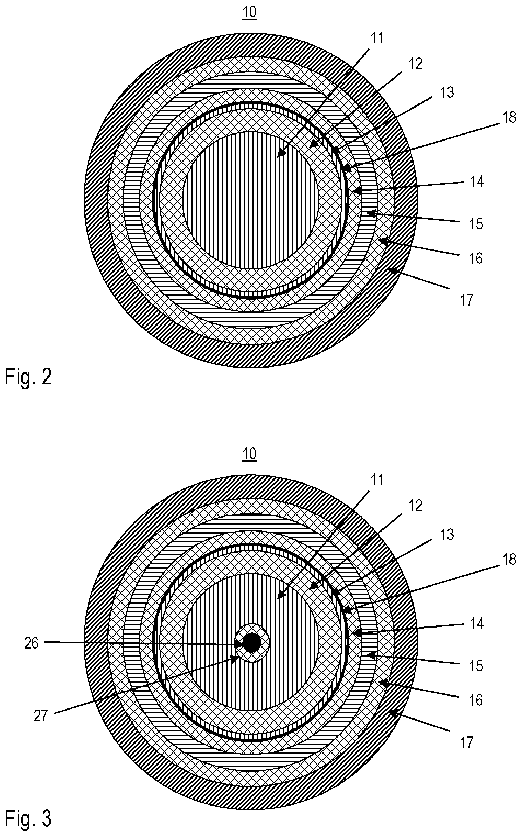

In Figur 2 ist ein Querschnitt durch die Vakuumdurchführung 10 gezeigt. In einer bevorzugten Ausführungsform ist die Abfolge der Materialien von innen nach aussen: Saphir (senkrecht schraffiert), Glas (diagonal gekreuzt schraffiert), Saphir, Platin (schwarz), Glas, Keramik (horizontal schraffiert), Glas, Metall (diagonal schraffiert). Die erste elektrisch leitende Schicht 18 ist elektrisch vom metallischen Rahmen 17 isoliert. Die Elemente der schalenförmig aufgebauten Durchführung sind mit den angrenzenden Elementen jeweils vakuumdicht verbunden.

In Figur 3 ist ein Querschnitt durch eine Ausführungsform der Vakuumdurchführung 10 gezeigt, welche eine zusätzliche zentrale Elektrode 26 durch das Linsenelement hindurch aufweist. Die zusätzliche Elektrode ist mittels eines zusätzlichen Rings 27 ins Linsenelement eingeglast. Die zusätzliche Elektrode kann Stab- oder Drahtförmig ausgebildet sein und beidseitig, d.h. vakuumseitig und atmosphärenseitig über die Durchführung hinausragen.

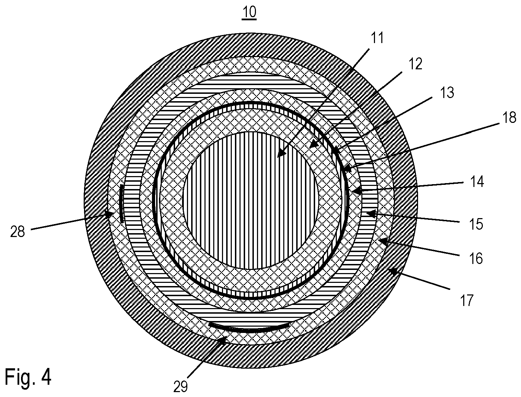

In Figur 4 ist ein Querschnitt durch eine Ausführungsform der Vakuumdurchführung 10 gezeigt, welche weitere, radial im Bereich des zweiten Rings 16 aus Glas angeordnete Elektroden 28, 29 aufweist. Beispielhaft sind hier zwei weitere Elektroden gezeigt, es können aber eine Mehrzahl derartige Elektroden in Form von azimutal voneinander beabstandeten Streifen mit einer Längsrichtung parallel zur Achse der Hohlzylinder auf diesem Radius angeordnet sein. Eine dieser weiteren Elektroden kann beispielsweise die zentrale Elektrode 26 aus dem Ausführungsbeispiel gemäss Fig. 3 ersetzen. In einer weiteren Ausführungsform kann die zentrale Elektrode aus Fig. 3 auch mit weiteren radial weiter aussen angeordneten Elektroden gemäss Fig. 4 kombiniert werden. Die weiteren Elektroden 28, 29 können beispielsweise als dünne Metallisierungen auf den Hohlzylinder 15 aus Keramik aufgebracht sein und durch den zweiten Ring 16 aus Glas auf der vom Keramikzylinder abgewandten Seite vakuumdicht ummantelt sein. Als Material für die weiteren Elektroden kommen verschiedene Metalle in Frage, insbesondere Platin, Molybdän und Titan. Über die weiteren Elektroden können beispielsweise weitere Plasmakammern und/oder Sensoren auf der Vakuumseite elektrisch kontaktiert werden, beispielsweise ein Kaltkathoden-Vakuummanometer oder ein Pirani-Drucksensor. Um auf der Aussenseite einen elektrischen Kontakt auf derartige weitere Elektroden zu ermöglichen, kann beispielsweise und abweichend von der Darstellung in Fig. 1, der Keramikzylinder 15 auch auf der von der Vakuumseite abgewandten Seite der Vakuumdurchführung über den Ring 16 hinausragen und so auch auf dieser Seite eine Auflagefläche für die weiteren Elektroden zu bilden und auf der radial äusseren Seite eine elektrische Kontaktierung zu ermöglichen. Solche weiteren Elektroden können beispielsweisen über ihre komplette Länge mit einer Isolierschicht abgedeckt sein. Dies hat den Vorteil, dass in der Elektronen-/Ionenoptik oftmals unerwünschte offenliegende Potentiale, welche geladene Teilchen beeinflussten könnten, vermieden werden. Dazu kann beispielsweise ein über den Elektroden liegender Glasring weiter axial ausgedehnt werden oder einzelnen Leiterbahnen können mit einer dünnen Glasschicht, welche überlappend über der jeweiligen Leiterbahn liegt, verwirklicht sein.

Zusammenfassend ermöglicht die vorliegende Erfindung eine Druckmessung oder eine Gasanalyse im Bereich
0.047 - 199.98 kPa (0.35 - 1500 Torr), also bis in den Überdruckbereich, beispielsweise mittels einer zylinderförmigen Saphir-Hochspannungsdurchführung mit integriertem Linsensystem. Ein DBD-Plasma kann durch Anlegen einer Wechselspannung im Bereich 1-10 Kilovolt und mit einer Frequenz im Bereich 1-10 Kilohertz gezündet werden. Die Erfindung ermöglicht ein kleines, energieeffizientes und flexibel einsetzbares Gasanalysegerät mit hoher Sensitivität und für verschiedenste Anwendungen.

### Bezugszeichenliste

- 1: Dichtfläche
- 2: erste Seite (Vakuumseite)
- 3: zweite Seite (Atmosphärenseite)
- 4: gemeinsame Achse
- 10: Vakuumdurchführung
- 11: Linsenelement
- 12: erster Ring (Glas)
- 13: erster Hohlzylinder (erstes dielektrisches Material)
- 14: zweiter Hohlzylinder (Glas)
- 15: dritter Hohlzylinder (Keramik)
- 16: zweiter Ring (Glas)
- 17: Rahmen (Metall)
- 18: erste elektrisch leitende Schicht
- 19: Kontaktfläche
- 20: Elektrodenanordnung
- 21: vierter Hohlzylinder (Keramik)
- 22: zweite elektrische leitende Schicht
- 23: axialer Überlappbereich
- 24: Spalt
- 25: Entladungszone im Spalt
- 26: zusätzliche (zentrale) Elektrode
- 27: zusätzlicher Ring (Glas)
- 28, 29: weitere Elektroden
- 30: Vorrichtung
- 31: Vakuumkammer
- 32: Wechselspannungs-Hochspannungsquelle
- 40: Messgerät
- 41: optischer Sensor

## Patentansprüche

1. Vakuumdurchführung (10), umfassend die Elemente
- Linsenelement (11),
- erster Ring (12) aus Glas,
- erster Hohlzylinder (13) aus einem ersten dielektrischen Material,
- erste elektrisch leitende Schicht (18),
- zweiter Hohlzylinder (14) aus Glas,
- dritter Hohlzylinder (15) aus Keramik,
- zweiter Ring aus Glas (16),
- Rahmen (17) aus Metall,
in der genannten Abfolge radial von innen nach aussen, wobei zumindest ein durchgehender Strahlungspfad existiert für eine Strahlung aus einem optischen Wellenlängenbereich ausgehend von einem ersten Punkt auf einer ersten Seite (2) der Vakuumdurchführung, durch das Linsenelement hindurch zu einem zweiten Punkt auf einer zweiten Seite (3) der Vakuumdurchführung.

2. Vakuumdurchführung (10) nach Anspruch 1,
wobei aneinandergrenzende Elemente (11,12,13,14,15,16,17) vakuumdicht miteinander verbunden sind zur Ausbildung einer Dichtfläche (1), welche die erste Seite (2) und die zweite Seite (3) der Vakuumdurchführung voneinander trennt,
wobei auf der Aussenfläche des ersten Hohlzylinders eine erste elektrisch leitende Schicht (18), insbesondere aus Platin, aufgebracht ist,
wobei der erste Hohlzylinder und die erste elektrisch leitende Schicht auf der zweiten Seite über den zweiten Hohlzylinder hinausragen zur Ausbildung einer elektrischen leitenden Kontaktfläche (19),
wobei der erste, zweite und dritte Hohlzylinder, sowie die erste elektrisch leitende Schicht auf der ersten Seite über das Linsenelement hinausragen.

3. Vakuumdurchführung (10) nach Anspruch 1 oder 2, wobei das Linsenelement (11) aus Saphir besteht.

4. Vakuumdurchführung (10) nach einem der Ansprüche 1 bis 3, wobei der erste Hohlzylinder (13) aus Saphir besteht.

5. Elektrodenanordnung (20) zur Erzeugung einer DBD-Plasmaentladung, wobei die Elektrodenanordnung die Vakuumdurchführung (10) nach einem der Ansprüche 1 bis 4 umfasst und weiter einen vierten Hohlzylinder (21) aus Keramik umfasst, welcher auf seiner Aussenfläche eine zweite elektrisch leitende Schicht (22), insbesondere aus Molybdän, trägt,
wobei der vierte Hohlzylinder (21) auf der ersten Seite (2) der Vakuumdurchführung koaxial zum ersten Hohlzylinder (13) angeordnet ist und zumindest teilweise innerhalb des ersten Hohlzylinders liegt,
wobei die erste und die zweite elektrisch leitende Schicht in axialer Richtung teilweise überlappen,
und wobei zwischen der zweiten elektrisch leitenden Schicht und der Innenfläche des ersten Hohlzylinders ein Spalt (24) mit einer radialen Ausdehnung offen bleibt.

6. Elektrodenanordnung (20) nach Anspruch 5, wobei die radiale Ausdehnung des Spalts (24) weniger als 1 mm beträgt, insbesondere wobei die radiale Ausdehnung des Spalts zwischen 0.05 mm und 0.5 mm beträgt.

7. Vorrichtung (30) zur Erzeugung einer DBD-Plasmaentladung, wobei die Vorrichtung die Elektrodenanordnung (20) gemäss Anspruch einem der Ansprüche 5 oder 6 umfasst,
wobei der Spalt zwischen der zweiten elektrisch leitenden Schicht und der Innenfläche des ersten Hohlzylinders in fluiddynamischer Verbindung mit dem Innern der Vakuumkammer steht,
wobei die erste elektrisch leitende Schicht an der elektrischen leitenden Kontaktfläche mit einer Wechselspannungs-Hochspannungsquelle (32) elektrisch leitend verbunden ist, und wobei die zweite elektrisch leitende Schicht elektrisch leitend mit Masse verbunden ist.

8. Messgerät (40) zur Charakterisierung eines Drucks und/oder einer Gaszusammensetzung, wobei das Messgerät die Vorrichtung nach Anspruch 7 umfasst und wobei auf der Atmosphärenseite (3) des Linsenelements (11) ein optischer Sensor (41) angeordnet ist.

9. Verfahren zum Betrieb eines Messgeräts (40) nach Anspruch 8, wobei zwischen der ersten elektrisch leitenden Schicht (18) und der zweiten elektrisch leitenden Schicht (22) eine Wechselspannung mit einer Spannungsamplitude von 1 bis 10 Kilovolt und einer Frequenz im Bereich 1 bis 10 Kilohertz angelegt wird.

## Claims

1. Vacuum feedthrough (10) comprising the elements
- lens element (11),
- first ring (12) made of glass,
- first hollow cylinder (13) made of a first dielectric material,
- first electrically conductive layer (18),
- second hollow cylinder (14) made of glass,
- third hollow cylinder (15) made of ceramic,
- second ring of glass (16),
- frame (17) made of metal,
in the above sequence radially from inside to outside, wherein at least one continuous radiation path exists for radiation from an optical wavelength range starting from a first point on a first side (2) of the vacuum feedthrough, through the lens element to a second point on a second side (3) of the vacuum feedthrough.

2. Vacuum feedthrough (10) according to claim 1, wherein adjoining elements (11, 12, 13, 14, 15, 16, 17) are connected to one another in a vacuum-tight manner to form a sealing surface (1) which separates the first side (2) and the second side (3) of the vacuum feedthrough from one another, wherein a first electrically conductive layer (18), in particular of platinum, is applied to the outer surface of the first hollow cylinder,
wherein the first hollow cylinder and the first electrically conductive layer on the second side protrude beyond the second hollow cylinder to form an electrically conductive contact surface (19),
wherein the first, second and third hollow cylinders and the first electrically conductive layer on the first side protrude beyond the lens element.

3. Vacuum feedthrough (10) of claim 1 or 2, wherein the lens element (11) is made of sapphire.

4. Vacuum feedthrough (10) according to one of claims 1 to 3, wherein the first hollow cylinder (13) is made of sapphire.

5. Electrode assembly (20) for generating a DBD plasma discharge, wherein the electrode assembly comprises the vacuum feedthrough (10) according to one of claims 1 to 4, and further comprises a fourth hollow cylinder (21) made of ceramic which carries on its outer surface a second electrically conductive layer (22), in particular of molybdenum,
wherein the fourth hollow cylinder (21) is arranged on the first side (2) of the vacuum feedthrough coaxially with the first hollow cylinder (13) and lies at least partially inside the first hollow cylinder,
wherein the first and the second electrically conductive layer partially overlap in the axial direction,
and wherein a gap (24) with a radial extension remains open between the second electrically conductive layer and the inner surface of the first hollow cylinder.

6. Electrode assembly (20) according to claim 5, wherein the radial extension of the gap (24) is less than 1 mm, in particular wherein the radial extension of the gap is between 0.05 mm and 0.5 mm.

7. Device (30) for generating a DBD plasma discharge, wherein the device comprises the electrode assembly (20) according to one of claims 5 or 6,
wherein the gap between the second electrically conductive layer and the inner surface of the first hollow cylinder is in fluid dynamic communication with the interior of the vacuum chamber,
wherein the first electrically conductive layer is electrically conductively connected to an AC high voltage source (32) at the electrically conductive contact surface, and wherein the second electrically conductive layer is electrically conductively connected to ground.

8. Measuring device (40) for characterizing a pressure and/or a gas composition, wherein the measuring device comprises the device according to claim 7 and wherein an optical sensor (41) is arranged on the atmosphere side (3) of the lens element (11).

9. Method for operating a measuring device (40) according to claim 8, wherein an AC voltage having a voltage amplitude of 1 to 10 kilovolts and a frequency in the range of 1 to 10 kilohertz is applied between the first electrically conductive layer (18) and the second electrically conductive layer (22).

## Revendications

1. Conduite de vide (10) comprenant dans l'ordre suivant radialement, de l'intérieur vers l'extérieur, les éléments suivants
- un élément de lentille (11),
- un premier anneau (12) en verre,
- un premier cylindre creux (13) constitué d'un premier matériau diélectrique,
- une première couche électriquement conductrice (18),
- un deuxième cylindre creux (14) en verre,
- un troisième cylindre creux (15) en céramique,
- un deuxième anneau en verre (16),
- un cadre (17) en métal,
au moins un trajet de rayonnement continu existant pour un rayonnement d'une plage de longueurs d'onde optique depuis un premier point sur un premier côté (2) de la conduite de vide, à travers l'élément de lentille, jusqu'à un deuxième point sur un deuxième côté (3) de la conduite de vide.

2. Conduite de vide (1) selon la revendication 1,
dans laquelle les éléments adjacents (11, 12, 13, 14, 15, 16, 17) sont raccordés les uns aux autres de façon étanche au vide pour former une surface d'étanchéité (1) qui sépare le premier côté (2) et le deuxième côté (3) de la conduite de vide,
dans laquelle il est monté sur la surface extérieure du premier cylindre creux une première couche électriquement conductrice (18), en particulier en platine,
dans laquelle le premier cylindre creux et la première couche électriquement conductrice font saillie sur le deuxième côté au-dessus du deuxième cylindre creux pour former une couche de contact électriquement conductrice (19),
dans laquelle le premier, le deuxième et le troisième cylindres creux, ainsi que la première couche électriquement conductrice, font saillie sur le premier côté au-dessus de l'élément de lentille.

3. Conduite de vide (10) selon la revendication 1 ou 2, dans laquelle l'élément de lentille (11) est en saphir.

4. Conduite de vide (10) selon l'une des revendications 1 à 3, dans laquelle le premier cylindre creux (13) est en saphir.

5. Agencement d'électrodes (20) pour produire une décharge de plasma DBD, l'agencement d'électrodes comprenant la conduite de vide (10) selon l'une des revendications 1 à 4 et comprenant en outre un quatrième cylindre creux (21) en céramique qui porte sur sa surface extérieure une deuxième couche électriquement conductrice (22), en particulier en molybdène,
le quatrième cylindre creux (21) étant agencé sur le premier côté (2) de la conduite de vide de façon coaxiale par rapport au premier cylindre creux (13) et reposant au moins en partie dans le premier cylindre creux,
la première et la deuxième couches électriquement conductrices se chevauchant en partie dans le sens axial, et un interstice (24) entre la deuxième couche électriquement conductrice et la surface intérieure du premier cylindre creux restant ouvert en s'étendant dans le sens radial.

6. Agencement d'électrodes (20) selon la revendication 5, dans lequel l'étendue radiale de l'interstice (24) est inférieure à 1 mm, l'étendue radiale de l'interstice étant notamment comprise entre 0,05 mm et 0,5 mm.

7. Dispositif (30) pour produire une décharge de plasma DBD, le dispositif comprenant l'agencement d'électrodes (20) selon l'une des revendications 5 ou 6,
dans lequel l'interstice entre la deuxième couche électriquement conductrice et la surface intérieure du premier cylindre creux est en liaison fluidodynamique avec l'intérieur de la chambre sous vide,
dans lequel la première couche électriquement conductrice au niveau de la surface de contact électriquement conductrice est raccordée électriquement à une source de haute tension alternative, et dans lequel la deuxième couche électriquement conductrice est raccordée électriquement à la masse.

8. Appareil de mesure (40) pour caractériser une pression et/ou une composition de gaz, l'appareil de mesure comprenant le dispositif selon la revendication 7, et un capteur optique (41) étant agencé sur le côté atmosphère (3) de l'élément de lentille (11).

9. Procédé pour faire fonctionner un appareil de mesure (40) selon la revendication 8, dans lequel on applique entre la première couche électriquement conductrice (18) et la deuxième couche électriquement conductrice (22) une tension alternative avec une amplitude de tension comprise entre 1 et 10 kilovolt et une fréquence comprise entre 1 et 10 kilohertz.
